# EUROPEAN PATENT APPLICATION

(11) **EP 2 953 156 A1**
(43) Date of publication of application: **09.12.2015**
(21) Application number: 14305831.1
(22) Date of filing: 02.06.2014
(51) Int. Cl.: H01L 21/02

(54) **Usage of TMDSO for depositing a silicon dioxide layer on a substrate.**

(71) Applicant: L'AIR LIQUIDE, SOCIETE ANONYME POUR L'ETUDE ET L'EXPLOITATION DES PROCEDES GEORGES CLAUDE, 75007 Paris (FR); CENTRE NATIONAL DE LA RECHERCHE SCIENTIFIQUE, 75794 Paris Cedex 16 (FR); L'ECOLE POLYTECHNIQUE, 91120 Palaiseau (FR)
(72) Inventor: Goyal, Prabal, 91120 Palaiseau (FR); Lahootun, Vanina, 91270 Vigneux sur Seine (FR); Johnson, Erik, 75020 Paris (FR)
(74) Representative: Grout de Beaufort, François-Xavier

(57) **Abstract**

A method for deposing on a substrate a silicon dioxide layer comprising introducing into a deposition zone where the substrate is located a gas mixture comprising :
- Tetramethyldisiloxane (TMDSO) ; and
- argon and CO₂.

## Description

The invention concerns the use of TMDSO for the deposition of silicon dioxide (SiO₂) films on a substrate surface (silicon wafers, glass, metals).

The SiO₂ layer is useful for the rear side passivation layer in crystalline solar cells.

Depending on the nature of the oxidant gas and their ratios, the properties of the films varies. With an increase in the oxidant content, more oxygen is incorporated in the films and the material gets a reduced refractive index (compared to Si) but the electrical conductivity decreases and the structure of the material changes from highly crystalline to fully amorphous.

There is a need for depositing SiO₂ film on a substrate surface with superior qualities, notably conductivity and transparency with better control of film properties during the deposition processes and thus resulting in thin film Si solar cells with improved efficiencies.

Consequently, an object of the present invention is: a method for deposing on a substrate a silicon dioxide layer comprising introducing into a deposition zone where the substrate is located a gas mixture comprising :
- Tetramethyldisiloxane (TMDSO); and
- argon and CO₂.

According to other embodiments, the invention concerns:
A method as defined above, wherein the deposition is performed by chemical vapour deposition and comprises at least one cycle comprising the following steps:
   (i) introducing Tetramethyldisiloxane (TMDSO) into a deposition zone where the substrate is located; and
   (ii) introducing the gas mixture of argon and CO₂ into the deposition zone.

A method as defined above, wherein the steps are performed simultaneously.

A method as defined above, wherein the steps are performed sequentially.

A method as defined above, wherein the temperature maintained in the deposition zone is comprised between 150°C and 250°C and the pressure maintained in the deposition zone is comprised between 133 Pa and 333 Pa.

A method as defined above, wherein the TMDSO is added to the gas mixture in a range comprised, in volume, between 1% and 2%.

In TMDSO, there is one Oxygen atom and two Silicon atoms. This results in a better control of the properties of the deposited films and serves as an extra source of Silicon which leads to the formation of denser Silicon thin films. These enhanced properties enable to achieve high efficiency thin film solar cells.

TMDSO has been used for depositing SiO₂ film on a substrate surface with superior qualities, notably conductivity and transparency. This molecule gives better control of film properties during the deposition processes and thus results in thin film Si solar cells with improved efficiencies.

This molecule presents advantages over the conventional water, oxygen, N₂O or CO₂ as source of oxygen atom in the deposition of SiO₂ film on a substrate surface in the following ways:
1. TMDSO has only one Oxygen atom and two Silicon atoms. During the deposition in a CVD system, the oxidation of amorphous Silicon will be limited and two additional Silicon atoms will result in the deposition of denser intrinsic and SiO₂ film.
2. TMDSO has sufficient volatility for vapour phase distribution and can be distributed easily using a conventional liquid molecule distribution system.

Those skilled in the art will recognise that these molecules can also be used for various other applications like deposition of SiOC films which have a higher band gap and can be used in the doped layers of a thin film Si Solar cell.

A preferred method for deposition of silicon dioxide thin films is as following:
1. A mixture of 1 % to 2% of TMDSO is used in Argon;
2. The flow rate of TMDSO ranges from 0 to 5 sccm;
3. The power densities can be ranged from 0 to 500 mW/cm²;
4. The applied pressure was between 133 Pa and 333 Pa;
5. The temperature of the substrate ranges from 150°C and 250°C.

### EXAMPLES

### Silicon dioxide films

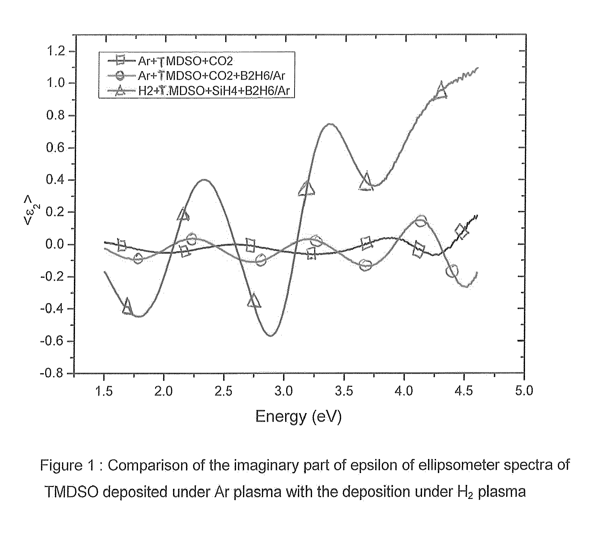

The SiO₂ film is deposited using a gas mixture of Argon, CO₂ and TMDSO under CVD conditions. Figure 1 compares the ellipsometric spectra of the films deposited in an Argon plasma with TMDSO and CO₂, and in a Hydrogen plasma with TMDSO, SiH₄ and B₂H₆. The SiO₂ layer is useful for the rear side passivation layer in crystalline solar cells. The intensity of ellipsometry spectra is low (transparent depositions on glass) and the fitting using ellipsometry software also shows that the deposition is close to SiO₂.

## Claims

1. A method for deposing on a substrate a silicon dioxide layer comprising introducing into a deposition zone where the substrate is located a gas mixture comprising :
- Tetramethyldisiloxane (TMDSO); and
- argon and CO₂.

2. A method according to Claim 1, wherein the deposition is performed by chemical vapour deposition and comprises at least one cycle comprising the following steps:
(i) introducing Tetramethyldisiloxane (TMDSO) into a deposition zone where the substrate is located; and
(ii) introducing the gas mixture of argon and CO₂ into the deposition zone.

3. A method according to Claim 2, wherein the steps are performed simultaneously.

4. A method according to Claim 2, wherein the steps are performed sequentially.

5. A method according to anyone of preceding claims, wherein the temperature maintained in the deposition zone is comprised between 150°C and 250°C and the pressure maintained in the deposition zone is comprised between 133 Pa and 333 Pa.

6. A method according to anyone of claims 2 to 5, wherein the TMDSO is added to the gas mixture in a range comprised, in volume, between 1% and 2%.
